Europäisches Patentamt

European Patent Office

Office européen des brevets

(19)

(11) Publication number: **0 008 903**
**B1**

(12) **EUROPEAN PATENT SPECIFICATION**

(45) Date of publication of patent specification: **14.04.82**

(51) Int. Cl.³: **H 01 L 27/04, H 01 L 21/76**

(21) Application number: **79301700.5**

(22) Date of filing: **20.08.79**

(54) Semiconductor integrated circuit device.

(30) Priority: **25.08.78 JP 116318/78 U**

(43) Date of publication of application:
**19.03.80 Bulletin 80/6**

(45) Publication of the grant of the patent:
**14.04.82 Bulletin 82/15**

(84) Designated Contracting States:
**DE FR GB NL**

(56) References cited:
**DE - A - 2 216 642**
**DE - A1 - 2 437 431**
**DE - B2 - 1 564 547**

**IBM Technical Disclosure Bulletin volume 17, no.**
**2, July 1974**
**New York**
**V.L. GANI et al.**
**"Dual-diode logic gate and oscillation clamping**
**structure" page 414**

(73) Proprietor: **FUJITSU LIMITED**
**1015, Kamikodanaka Nakahara-ku**
**Kawasaki-shi Kanagawa 211 (JP)**

(72) Inventor: **Fukushima, Toshitaka**
**1604-442 Shiomidai**
**Isogo-ku Yokohama-shi, Kanagawa 235 (JP)**

(74) Representative: **Rackham, Stephen Neil et al,**
**GILL JENNINGS & EVERY**
**53/64 Chancery Lane London WC2A 1HN (GB)**

(56) References cited:
**IBM Technical Disclosure Bulletin Volume 19, no.**
**6, November 1976**
**New York**
**M.A. Battista et al.**
**"Variable transition device transistor" pages**
**2073 to 2074**

Courier Press, Leamington Spa, England.

## Semiconductor Integrated Circuit Device

The present invention relates to the structure of a semiconductor integrated circuit device.

In the manufacture of semiconductor integrated circuit devices, the process of forming circuit elements having a pnpn structure, such as a thyristor, into the device in a lateral arrangement comprises forming an n type epitaxial layer on a p type silicon semiconductor substrate, then forming a first and a second p type regions on the epitaxial layer, followed by forming an n type region in the second p type region. In such a pnpn structure, a parasitic transistor may be formed by the p type region, the n type epitaxial layer and the p type silicon semiconductor substrate. The formation of such a parasitic transistor causes a phenomenon that when the pn junction between the p type region and the n type epitaxial layer is forward-biased, the parasitic transistor turns on to allow a leakage current to flow from the p type region via n type region to the p type silicon semiconductor substrate.

To overcome this disadvantage in the past an $n^+$ type buried layer has been formed between a portion of the n type epitaxial layer enclosed by an isolsation region and the p type silicon semiconductor substrate, to reduce the current amplification factor $\alpha$ of the parasitic transistor to lessen the possibility of the transistor turning on. However, with this conventional structure, the integrated circuit cannot withstand a high voltage. In addition, a deep isolation region is required to traverse the epitaxial layer. Since the isolation region has a large depth, it also has to have a large surface area so that the region occupies a large part of the surface of the epitaxial layer and so reduces the number of circuit elements that can be formed in a unit area. Furthermore, an uneven surface is caused in the epitaxial layer, so that disconnections in an aluminium wiring layer applied over it are frequently caused.

The IBM Technical Disclosure Bulletin Volume 17, No 2, July 1974 at page 414 includes an article by V. L. Gani et al entitled "Dual-diode logic gate and oscillation clamping structure". This article illustrates the construction of a semiconductor device having a substrate, a buried layer and an epitaxial layer. The device forms a logic gate with clamping diodes connected to the inputs of the gate. The diodes are formed in the epitaxial layer above the buried layer and are isolated from the logic gate by outer isolation regions which are located outside the buried layer and which extend through the epitaxial layer and down into the substrate and are isolated from each other by further strip isolation regions extending between the two sets of diodes and between the diodes and the logic gate inputs. The further strip isolation regions extend through the epitaxial layer and into the buried layer and are shallower than the outer isolation regions. The further strip isolation regions simply serve to isolate the two diodes connected to each input of the gate. This semiconductor device only includes diodes as the circuit elements formed by the epitaxial layer and thus since there are no lateral pn devices in the epitaxial layer no parasitic transistors are formed including the epitaxial layer and the substrate.

According to this invention a semiconductor integrated circuit device including a semiconductor substrate of one conduction type, an epitaxial layer of opposite conduction type formed on the substrate, a buried layer of opposite conduction type located between the substrate and the epitaxial layer, at least one circuit element formed in the epitaxial layer above the buried layer, a first isolation region spaced from the buried layer and extending from the surface of the epitaxial layer into the substrate, a second shallower isolation region located within the first isolation region and extending from the surface of the epitaxial layer into the buried layer, is characterised in that the first and second isolation regions completely surround the at least one circuit element, in that the surface of the substrate and hence of the epitaxial layer lie in the [100] crystal plane and in that the first and second isolation regions are formed by ansiotropic etching whereby the isolation regions both have a V-shaped cross-section, and thus, in spite of their different depths, are formed simultaneously.

An advantage of such an integrated circuit device is that a circuit element having a pn junction in a lateral arrangement can be provided, but, in this case the formation of a parasitic transistor is prevented. Also such a device can be made with an even or smooth surface and each of the circuit elements can be arranged within a small area thereby to increase the packing density of the circuit elements.

Various embodiments of integrated circuit devices in accordance with this invention will now be described and contrasted with earlier examples with reference to the accompanying drawings; in which:—

Figures 1A, 1B and 1C are all cross-sections through conventional semiconductor integrated circuit devices including a lateral pnpn structure;

Figures 2A, 2B and 2C are circuit diagrams to illustrate the equivalent circuits of the devices illustrated in Figures 1A, 1B and 1C, respectively;

Figures 3A and 3B are cross-sections through further examples of conventional semiconductor integrated circuit devices which are better than those illustrated in Figures 1A and 1B, respectively;

Figures 4A, 4B and 4C are cross-sections through embodiments of semiconductor integrated circuit devices in accordance with the present invention;

Figures 5A and 5B are cross-sections through further embodiments of semiconductor integrated circuit devices in accordance with the present invention; and,

Figures 6A and 6B are plans of the devices illustrated in Figures 4A and 5B.

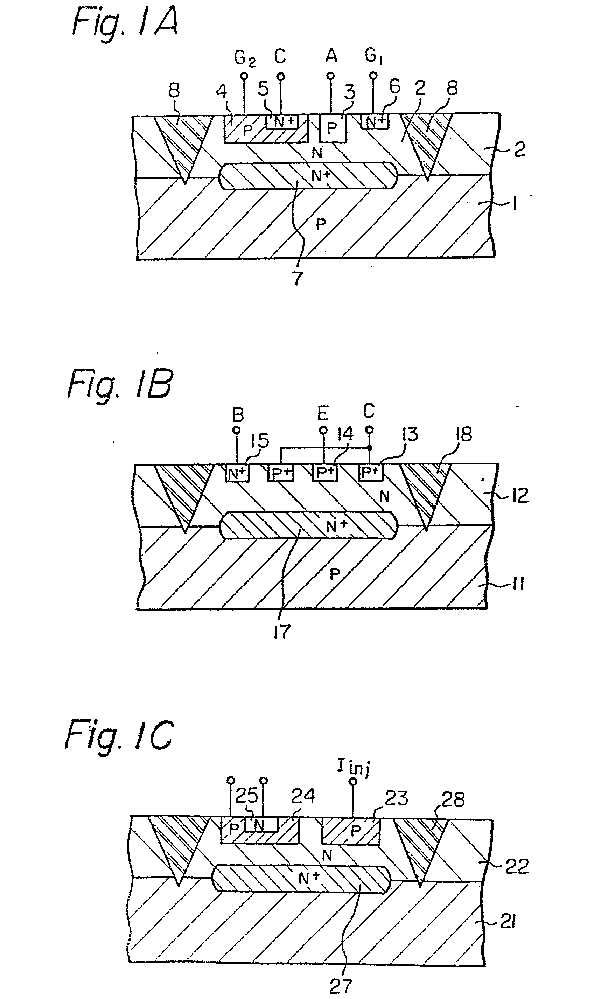

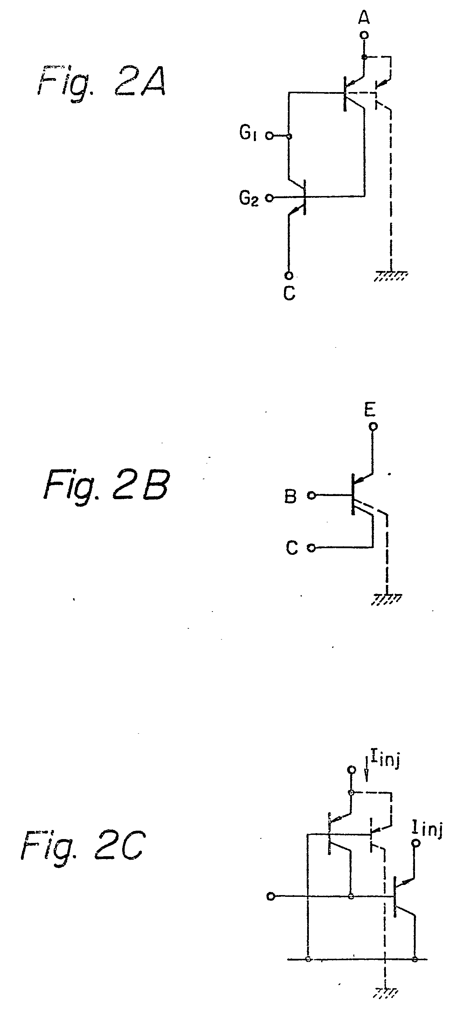

In the manufacture of a semiconductor integrated circuit device, such as thyristor, having a pnpn structure formed in a lateral arrangement as an element of an integrated circuit, as shown in Figure 1A, p type regions 3 and 4 are formed first on an n type epitaxial layer 2, which is formed on a substrate of a p type silicon semiconductor 1. Then an n type region 5 is formed in the p type region 4. In Figure 1A, reference numeral 6 designates a contact area in contact with an electrode $G_1$ and formed in the epitaxial layer 2, 7 an $n^+$ type buried layer and 8 an isolation region made of silicon dioxide or a combination of silicon dioxide and polysilicon. Figure 2A is a circuit diagram of the pnpn structure illustrated in Figure 1A.

In the above-described pnpn structure, a parasitic pnp transistor is formed by the p type region 3, the n type epitaxial layer 2 and the p type silicon semiconductor substrate 1, as indicated by a dotted line in Fig. 2A. As a consequence, during its operation, the pn junction between the p type region 3 and the n type epitaxial layer 2 is forward-biased, so that the parastic transistor turns on which results in a flow of leakage current from an anode terminal A toward the p type silicon semiconductor substrate 1.

Fig. 1B illustrates the arrangement of a conventional lateral transistor of pnpn structure. In Fig. 1B, reference numeral 11 designates a p type silicon semiconductor substrate, 12 an $n^+$ type epitaxial layer, 13 a $p^+$ type layer, 14 another $p^+$ type layer, 15 an $n^+$ type layer and 17 an $n^+$ type buried layer. Numeral 18 denotes a dielectric isolation region made of silicon dioxide or a combination of silicon dioxide and polysilicon. Even in this arrangement, a parastic transistor can be formed by the $p^+$ type layers 13, 14, the $n^+$ type epitaxial layer 12 and the p type silicon semiconductor substrate 11, so that the same disadvantage as in the circuit of Fig. 1A is caused. The equivalent circuit of the transistor of Fig. 1B is illustrated in Fig. 2B where the parasitic transistor is indicated by a dotted line.

Fig. 1C illustrates the pnpn transistor structure of ($I^2L$) Integrated-Injection Logic memory cell according to the conventional art. In Fig. 1C, reference numeral 21 denotes a p type silicon semiconductor substrate, 22 an n type epitaxial layer, 23 a p type region, 24 a further p type region, 25 an n type region and 27 an n type buried layer. Numeral 28 designates a dielectric isolation region composed of silicon dioxide or a combination of silicon dioxide and polysilicon. Also in this structure, a parasitic transistor can be formed between the p type region 23, the n type epitaxial layer 22 and the silicon semiconductor substrate 21, so that a diversion of the injection current, and accordingly, a current dissipation is caused. The equivalent circuit of this structure is illustrated in Figure 2C.

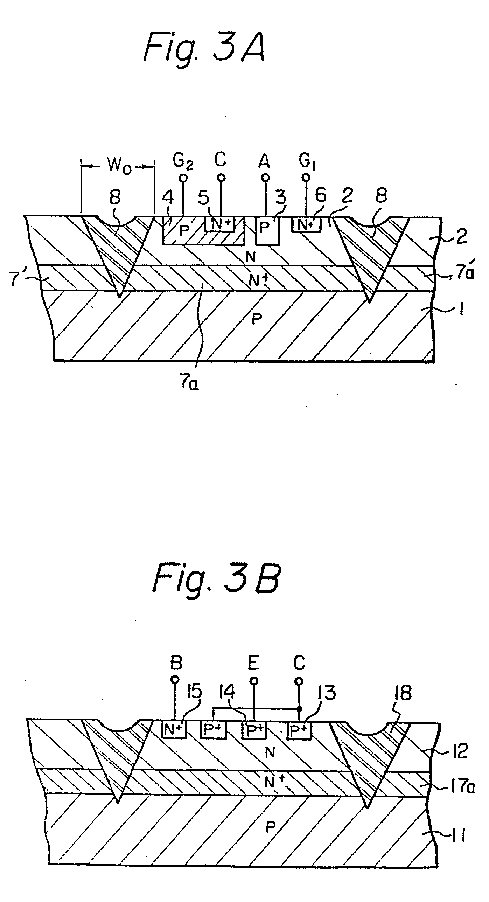

For the purpose of overcoming the above-mentioned disadvantage, it has been proposed to form an $n^+$ type buried layer 7', 7a, 7a' or 17a between the epitaxial layer 2 or 12 and the silicon semiconductor substrate 1 or 11, which extends over the entire area enclosed by the dielectric isolation region 8 or 18, as shown in Figures 3A and 3B, to reduce the current amplification factor $\alpha$ of the parasitic pnp transistor formed, so that the possibility of the transistor turning on can be decreased. However, this structure has the disadvantage that it is difficult to apply a high voltage to the integrated circuit employing this structure. Further, the dielectric isolation region 8 or 18 must have a sufficient depth for traversing the epitaxial layer 41. As a result, the portion of the region corresponding to the surface of the epitaxial layer 2 or 12 necessarily has a larger width Wo as compared with the dielectric isolation regions of the structures of Figures 1A and 1B, so that the surface of the dielectric region 8 or 18 occupies a larger part of the whole surface of the epitaxial layer. Further, the epitaxial layer 2 or 12 has an uneven surface, which may cause a disconnection in the aluminium-wired layer or the like formed on the structure.

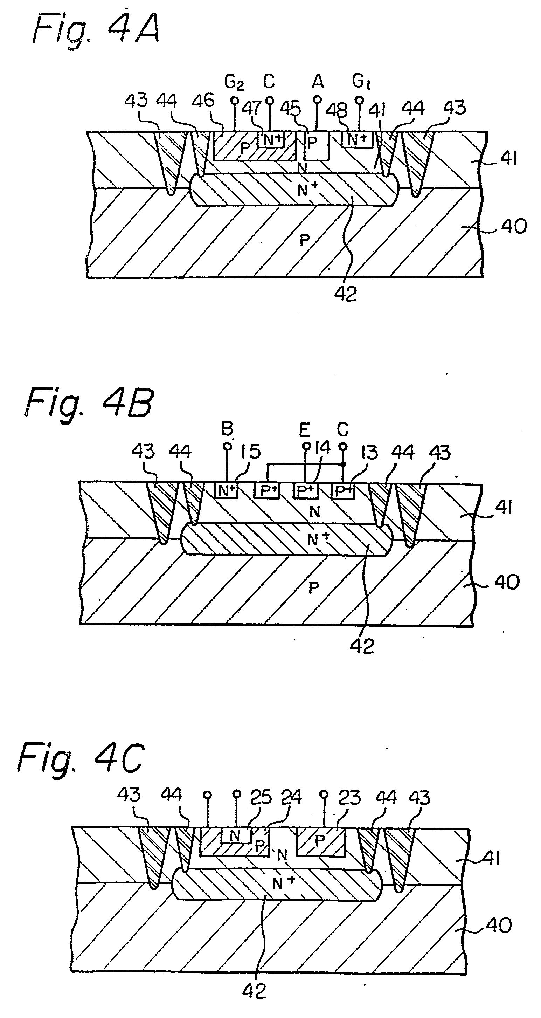

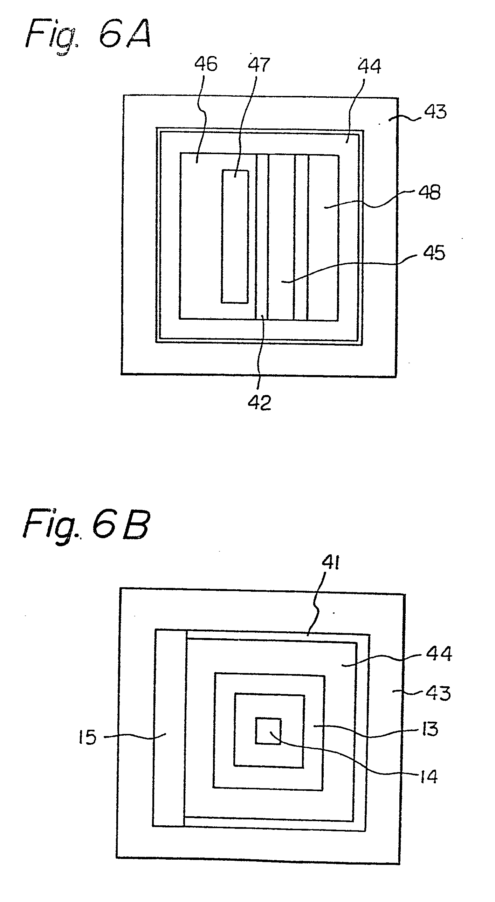

The device in accordance with this invention is shown in Figures 4A and 6 in which a p type silicon semiconductor substrate 40 having a plane index of [100] has a $n^-$ type epitaxial layer 41 formed on it and a buried layer 42 of $n^+$ type conduction type formed between the silicon semiconductor substrate 40 and the epitaxial layer 41. Since the substrate 40 has a plane index of [100] the epitaxial layer 41 grown on top of the substrate also has a plane index of [100]. An isolation region 43 is formed around the outer periphery of the buried layer 42. A leakage current blocking region 44 extends around the inside of the isolation region 43.

The isolation regions 43 and 44 have a V-shaped cross-section. The V-shaped region is formed by anisotropically etching the semiconductor using hydrazine solution to form a groove. With this type of etching the depth of the groove can be controlled by varying the width of the window of a mask used in the etching step. Thus when a wide width of the window of the mask is used, the depth of the V-groove increases. The V-shaped grooves of the isolation region 43 may be filled with a diffusion region of $p^+$ conduction type or an insulator such as silicon dioxide ($SiO_2$). Further, the V-shaped cross-section grooves of the current blocking region 44 may be filled by an insulator composed of silicon dioxide ($SiO_2$) an aluminium oxide, such as $Al_2O_3$ or a by silicon nitride, such

as $Si_3N_4$. Alternatively, the grooves of the current blocking region 44 may be filled by a first insulating layer on top of which a polysilicon layer is formed. The bottom of the region 43 extends into the substrate 40 whereas the region 44 is shallower and its bottom only extends into the buried layer 42.

p type regions 45 and 46 are formed in a portion of the n⁻ type epitaxial layer 41 enclosed by the dielectric isolation region 43. An n type region 47 is formed in the p type region 46, and an n type contact area 48 is formed in the epitaxial layer 41. An electrode $G_1$ is connected to the area 48. Symbol A denotes an anode electrode which is connected to the p type region 45, C a cathode electrode which is connected to the n type region 47, and $G_2$ a gate electrode which is connected to the p type region 46. In this device a thyristor of lateral pnpn arrangement is formed by the p type region 45, the n⁻ type epitaxial layer 41, the p type region 46 and the n type region 47.

With the arrangement shown in this example, the leakage current blocking region 44 is provided in the base region of the parasitic pnp transistor, which may be formed by the p type region, the n⁻ epitaxial layer 41 and the p type silicon semiconductor substrate 40. Since the parasitic transistor traverses the epitaxial layer 41, it has such a small current amplification factor $\alpha$ that it is almost inoperative as a transistor. As a result, even if a minority carrier is applied to the epitaxial layer 41 through the p type region 45, there occurs no flow of leakage current from the p type region 45 toward the p type silicon semiconductor substrate 40.

The isolation region 43 must have its bottom end reaching the silicon semiconductor substrate 40, but since the region is outside the buried layer it can be shallower than it would have needed to be if it had to penetrate the buried layer. Thus the surface area of the region 43 is smaller than it otherwise would be and consequently the region 43 only occupies a small area of the epitaxial layer 41.

Further, the isolation region 44 only has to reach the upper surface of the buried layer 42, which is above the upper surface of the silicon semiconductor substrate 40, and thus the region 44 is shallower than the region 43 and consequently its upper surface has an even smaller area than that of the region 43. Accordingly, the total area occupied by the circuit element is reduced thereby increasing the packing density.

In addition, since the epitaxial layer has a lower impurity concentration in the vicinity of its contact area with the silicon semiconductor substrate, the element forming region has a high withstand voltage.

Further, since the surface of the isolation regions 43 and 44 are both so small in area that the semiconductor integrated circuit can be formed with an even or smooth surface which helps to prevent a disconnection in the wired layer formed thereon.

By selecting the width of the window of the mask for the region which forms the isolation region 43 to be larger than the width of the window of the mask for the region 44, the region 44 which only reaches the buried layer 42 is shallower than the region 43 which reaches the semiconductor substrate 40. The two regions are formed at the same time by same etching process.

Figure 4B illustrates an improvement in the example shown in Figure 1B to modify it in accordance with the present invention. In Figure 4B, like numerals and symbols are given to parts corresponding to those in Figure 1B. Also in Figure 4C, parts corresponding to those in Figure 1C are given like numerals and symbols. Similar results to those mentioned above with regard to the arrangement of Figure 4A occur with the arrangement illustrated in Figures 4B and 4C.

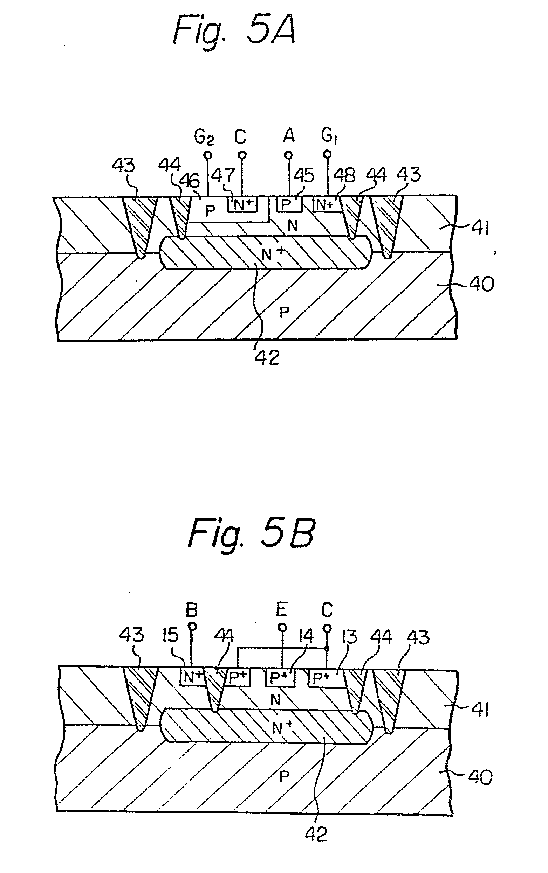

Figures 5A and 5B illustrate further examples in accordance with this invention. The difference in the arrangement of the version shown in Figure 5A from that shown in Figure 4A lies in the fact that the leakage current blocking region 44 is arranged in contact with the n type region 48 and the p type region 46, whilst the arrangement of Figure 5B is distinguished from that of Figure 4B in that a leakage current blocking region 44 is arranged in contact with the p type region 13 and the n type region 15. Thus, in both of these examples, the surface area of the structure occupied by the leakage current blocking region and the dielectric isolation region is smaller than the examples shown in Figures 4A and 4B to increase the packing density still further. A plan view of the arrangement shown in Figure 5B is illustrated in Figure 6B.

The present invention enables a semiconductor integrated circuit to be manufactured which prevents the formation of a parasitic transistor therein which can be formed with an even or smooth surface and in which the circuit elements can be integrated within a small area to increase its packing density.

**Claims**

1. A semiconductor integrated circuit device including a semiconductor substrate (40) of one conduction type, an epitaxial layer (41) of opposite conduction type formed on the substrate (40), a buried layer (42) of opposite conduction type located between the substrate (40) and the epitaxial layer (41), at least one circuit element (45, 46, 47, 48) formed in the epitaxial layer (41) above the buried layer (42), a first isolation region (43) spaced from the buried layer (42) and extending from the surface of the epitaxial layer (41) into the substrate (40), a second shallower isolation region (44) located within the first isolation region (43) and extending from the surface of the epitaxial layer (41) into the buried layer (42), the integrated circuit device being characterised in that the first and second isolation regions (43, 44) completely surround the at least one circuit element (45, 46, 47, 48), in that the surface of the substrate (40) and hence of the epitaxial layer (41) lie in the [100] crystal plane, and in that the first and second isolation regions (43, 44) are formed by anisotropic etching whereby the isolation regions (43, 44) both have a V-shaped cross-section, and thus, in spite of their different depths, are formed simultaneously.

2. A semiconductor integrated circuit device according to claim 1, further characterised in that the at least one circuit element is a lateral pnpn-type device.

3. A semiconductor integrated circuit device according to claim 1 or claim 2, further characterised in that the material forming the first and/or second isolation regions (43, 44) is an oxidised substance.

4. A semiconductor integrated circuit device according to claim 3, further characterised in that the oxidised substance is an oxide of silicon or aluminium.

5. A semiconductor integrated circuit device according to claim 1 or 2, further characterised in that the material forming the first and/or second isolation regions (43, 44) is a silicon nitride.

6. A semiconductor integrated circuit device according to claims 1 or 2, further characterised in that the material forming the first and/or second isolation regions (43, 44) is formed by an insulating layer on which a polysilicon layer is formed.

## Patentansprüche

1. Integrierte Halbleiterschaltungsanordnung mit einem Halbleitersubstrat (40) eines Leitungstyps, mit einer Epitaxialschicht (41) eines entgegengesetzten Leitungstyps, die auf dem Substrat (40) gebildet ist, mit einer vertieften Schicht (42) des entgegengesetzten Leitungstyps, die zwischen dem Substrat (40) und der Epitaxialschicht (41) angeordnet ist, mit wenigstens einem Schaltungselement (45, 46, 47, 48), das in der Epitaxialschicht (41) über der vertieften Schicht (42) gebildet ist, mit einer Isolierzone (43), die im Abstand von der vertieften Schicht (42) angeordnet ist und die sich von der Oberfläche der Epitaxialschicht (41) in das Substrat (40) erstreckt, und mit einer zweiten flacheren Isolierzone (44), die innerhalb der ersten Isolierzone (43) angeordnet ist und sich von der Oberfläche der Epitaxialschicht (41) in die vertiefte Schicht (42) erstreckt, dadurch gekennzeichnet, daß die erste und die zweite Isolierzonen (43, 44) vollständig wenigstens ein Schaltungselement (45, 46, 47, 48) umgeben, daß die Oberfläche des Substrats (40) und somit der Epitaxialschicht (41) in der [100]-Kristallebene liegt und daß die erste und die zweite Isolierzone (43, 44) durch

anisotropes Ätzen gebildet sind, wobei beide Isolierzonen (43, 44) einen V-förmigen Querschnitt haben und somit trotz ihrer unterschiedlichen Tiefen gleichzeitig gebildet sind.

2. Integrierte Halbleiterschaltungsanordnung nach Anspruch 1, dadurch gekennzeichnet, daß wenigstens ein Schaltungselement eine pnpn-Vorrichtung in seitlicher Richtung ist.

3. Integrierte Halbleiterschaltungsanordnung nach Anspruch 1 oder 2, dadurch gekennzeichnet, daß das die erste und/oder zweite Isolierzone (43, 44) bildende Material ein oxidierter Stoff ist.

4. Integrierte Halbleiterschaltungsanordnung nach Anspruch 3, dadurch gekennzeichnet, daß der oxidierte Stoff ein Silizium- oder Aluminiumoxid ist.

5. Integrierte Halbleiterschaltungsanordnung nach Anspruch 1 oder 2, dadurch gekennzeichnet, daß das die erste und/oder zweite Isolierzone (43, 44) bildende Material ein Siliziumnitrid ist.

6. Integrierte Halbleiterschaltungsanordnung nach Anspruch 1 oder 2, dadurch gekennzeichnet, daß das die erste und/oder zweite Isolierzone (43, 44) bildende Material durch eine Isolierschicht gebildet ist, auf der eine Polysiliziumschicht gebildet ist.

## Revendications

1. Dispositif à circuit intégré semiconducteur comportant un substrat semiconducteur (40) d'un premier type de conduction, une couche épitaxiale (41) d'un type de conduction opposé formée sur le substrat (40), une couche enterrée (42) du type de conduction opposé située entre le substrat (40) et le couche épitaxiale (41), au moins un élément de circuit (45, 46, 47, 48) formé dans la couche épitaxiale (41) au-dessus de la couche enterrée (42), une première région isolée (43) écartée de la couche enterrée (42) et s'étendant de la surface de la couche épitaxiale (41) jusque dans le substrat (40), une deuxième région isolée (44) moins profonde située à l'intérieur de la première région isolée (43) et s'étendant de la surface de la couche épitaxiale (41) jusque dans la couche enterrée (42), le dispositif à circuit intégré étant caractérisé en ce que la première et la deuxième région isolée (43, 44) entourent complétement le ou les éléments de circuit (45, 46, 47, 48), en ce que la surface du substrat (40) et, par conséquent, de la couche épitaxiale (41) se trouve dans le plan cristallin [100], et en ce que la première et la deuxième région isolée (43, 44) sont formées par attaque préférentielle, de sorte que les régions isolées ont toutes deux une section droite en forme de V et, par conséquent, en dépit de leurs profondeurs différentes, sont formées simultanément.

2. Dispositif à circuit intégré semiconducteur selon la revendication 1, caractérisé en outre en ce que l'élément de circuit est un dispositif de type pnpn latéral.

3. Dispositif à circuit intégré semiconducteur selon la revendication 1 ou la revendication 2, caractérisé en outre en ce que le matériau formant la première et, ou, la deuxième région isolée (43, 44) est une substance oxydée.

4. Dispositif à circuit intégré semiconducteur selon la revendication 3, caractérisé en outre en ce que la substance oxydée est un oxyde de silicium ou d'aluminium.

5. Dispositif à circuit intégré semiconducteur selon la revendication 1 ou 2, caractérisé en outre en ce que le matériau formant le première et, ou bien, la deuxième région isolée (43, 44) est un nitrure de silicium.

6. Dispositif à circuit intégré semiconducteur selon les revendications 1 ou 2, caractérisé en outre en ce que le matériau formant la première et, ou bien, la deuxième couche isolée (43, 44) est formé par une couche isolante sur laquelle une couche de silicium polycristallin est formée.

*Fig. 1A*

*Fig. 1B*

*Fig. 1C*

1

*Fig. 2A*

A

G₁

G₂

C

*Fig. 2B*

E

B

C

*Fig. 2C*

$I_{inj}$

$I_{inj}$

2

# Fig. 3A

# Fig. 3B

Fig. 4A

Fig. 4B

Fig. 4C

# Fig. 5A

# Fig. 5B

## Fig. 6A

## Fig. 6B